# EUROPEAN PATENT SPECIFICATION

(11) **EP 3 293 853 B1**
(45) Date of publication and mention of the grant of the patent: **20.11.2019**
(21) Application number: 15891164.4
(22) Date of filing: 10.07.2015
(51) Int. Cl.: H02H 1/00, H02J 13/00, G01R 19/25, G05B 23/02

(54) **SMART MULTI-DIMENSIONAL BIG DATA ANALYZING EXPERT SYSTEM FOR HIGH-VOLTAGE CIRCUIT BREAKER IN POWER GRID**
INTELLIGENTES EXPERTENSYSTEM ZUR ANALYSE MEHRDIMENSIONALER GROSSER DATENMENGEN FÜR HOCHSPANNUNGSSCHALTER IM STROMNETZ
SYSTÈME EXPERT D'ANALYSE DE MÉGADONNÉES MULTIDIMENSIONNELLES INTELLIGENT POUR DISJONCTEUR À HAUTE TENSION DANS UN RÉSEAU ÉLECTRIQUE

(30) Priority: 06.05.2015 CN 201510227151
(43) Date of publication of application: 14.03.2018
(73) Proprietor: Yang, Qibei, Nanning City, Guangxi 530029 (CN)
(72) Inventor: Yang, Qibei, Nanning City, Guangxi 530029 (CN)
(74) Representative: Conroy, John
(86) International application number: PCT/CN2015/083822
(87) International publication number: WO 2016/176913

(56) References cited:
- WO-A1-2009/079395
- WO-A1-2012/142355
- CN-A- 102 004 223
- CN-A- 103 457 247
- CN-U- 201 689 158
- KR-B1- 100 970 005
- US-A- 5 859 596
- US-A1- 2006 087 785
- US-B1- 6 195 243

## Description

### Technical Field

The present invention relates to the field of smart monitoring of a high voltage circuit breaker in a power grid, and particularly to a system which performs smart, real-time multi-dimensional big data analysis to a high-voltage circuit breaker or a high-voltage circuit breaker cluster in a power grid and is capable of providing running and maintenance decision-making references.

### Background Art

AC and DC power systems have a large number of circuit breaker elements, and these circuit breaker elements need to be intelligently monitored and controlled in real time. A common technical measure is to utilize a measurement and control apparatus to transmit positional signals of a circuit breaker and its auxiliary mechanism to a remote monitoring system, and the monitoring system then performs remote monitoring and control on the circuit breaker.

In electrical devices of a power system, the circuit breaker is one of the important control devices. The reliability of the circuit breaker is related directly to the safety and stability of the whole system, and many major accidents or the disaggregation and power outage of the system are related to a failure of the circuit breaker. As a core element of the power system, the circuit breaker has an extremely important effect in maintaining and ensuring the stable running of the power system. Main failures of the circuit breaker include mechanical failures, insulation failure, arc-extinguishing failure, heat faults of conductor parts and so on, with the mechanical failures occurring most frequently. Therefore, the timely understanding of the working state of the circuit breaker has a huge effect on the improvement of the reliability of power supply. Traditional circuit breaker online monitoring apparatuses mainly monitor parameters such as the number of mechanical operations of the circuit breaker and the cumulative running time of the switch. Most of the monitoring apparatuses have relatively simple functions, and monitor only the same kind of parameters of one or more devices. Such monitoring apparatuses cannot be combined with failure diagnosis techniques and online monitoring techniques, and can provide analysis and diagnosis that are only limited to warning in case of over standard.

Furthermore, various data from the existing automation systems are isolated from one another, and the integrated data of the circuit breaker are not specially summarized and analyzed. Therefore, the working condition of the circuit breaker cannot be evaluated, and thus a large amount of real-time monitored data lose their deserved value, which is not beneficial to economically maintain and manage the circuit breaker in the system. Consequently, it is difficult to timely perform scientific maintenance on the circuit breaker, which leads to progressive accumulation of major potential security hazards, and brings about great risks to the security of the power grid and personal safety.

US 2006/0087785 describes a circuit protector signal transmission system for at least one overcurrent circuit protector defining an interruptible current path therethrough upon an occurrence of specified current conditions through the interruptible current path, and a status element associated with the circuit protector and adapted to monitor an operating state of the current path.

US 5,859,596 describes a switchyard equipment monitoring system and communications network therefor.

WO 2009/079395 describes a system for real-time verification of protective device system configuration settings on a monitored system.

US 6,195,243 describes a load center monitor in a network of electronically controlled circuit breakers for providing monitoring, analysis and control of circuit breaker function.

WO 2012/142355 describes a dynamic assessment system for monitoring high-voltage electrical components, which includes a computer system that is configured to receive data from a plurality of on-line sensors configured to monitor various operating parameters associated with the operation of a plurality of electrical components such as a plurality of electrical transformers.

### Disclosure of the Invention

In view of the problems existing in the prior art, an object of the present invention is to provide a smart multi-dimensional big data analyzing expert system for a high-voltage circuit breaker in a power grid, which is a smart expert system for performing real-time monitoring and carrying out multi-dimensional big data analysis to a high-voltage circuit breaker in a power grid, and can monitor in real time whether the circuit breaker is in a normal state, and gather a vast amount of cloud data from real-time monitoring, technical supervision, security risk evaluation, warehoused spare parts and the like, to provide a decision basis for performing scientific maintenance and management with the help of the smart multi-dimensional big data analysis function.

The present invention provides a smart multi-dimensional big data analyzing expert system for a high-voltage circuit breaker in a power grid. The smart multi-dimensional big data analyzing expert system for a high-voltage circuit breaker in a power grid includes a high-voltage circuit breaker or high-voltage circuit breaker cluster (hereinafter collectively referred to as the circuit breaker) cloud database and a smart expert decision terminal. The circuit breaker cluster cloud database includes a real-time circuit breaker monitoring database, a circuit breaker technique supervision database, a circuit breaker security risk technical indicator database and a circuit breaker warehouse spare part database. The smart expert decision terminal includes a device security risk evaluation module, an optimal device maintenance solution ranking module and a mobile terminal online dynamic warning module. The circuit breaker cluster cloud database dynamically acquires data, and the smart expert decision terminal performs history data analysis, trend analysis, variable analysis, comparison analysis and factor analysis on the acquired data.

Furthermore, the real-time circuit breaker monitoring database includes a working voltage, a working current, states of opening and closing coils, positions of three-phase contacts, a counter for opening and closing actions, the state of an operating mechanism, a counter for actions of applying a voltage to a motor, the pressure of SF₆ gas, the position of an isolation switch, and the position of a grounded knife switch, which are acquired from a substation automation system and a field measurement and control apparatus.

Furthermore, action processes and breaking current values of the circuit breaker, which are in a circuit breaker protection apparatus, a line protection apparatus and a relevant-element (e.g., a main transformer, a bus, a reactor and a capacitor) protection apparatus, are acquired from a relay protection management information system of the substation automation system.

Furthermore, a fault recording apparatus is further included, and a value of a fault current broken by the circuit breaker and an action process of the three-phase contacts are acquired from the fault recording apparatus.

Furthermore, inherent design parameters of the circuit breaker are further included, and the inherent design parameters include: waveforms, speeds, time, overtravel, opening range and bounce that are related to opening and closing operations; the voltage and current of an operating coil; and the action time and power of an iron core.

The present invention also provides a method of monitoring a circuit breaker using the above mentioned smart multi-dimensional big data analyzing expert system for a high-voltage circuit breaker in a power grid, and the method includes the following steps:
step S111: acquiring, from a substation automation system and a field measurement and control apparatus, working parameters of a circuit breaker in a power grid, where the working parameters in the power grid include a working voltage and a working current of the circuit breaker, states of opening and closing coils, positions of three-phase contacts, a counter for opening and closing actions, a state of an operating mechanism, a counter for actions of applying a voltage to a motor, a pressure of SF₆ gas, a position of an isolation switch, and a position of a grounded knife switch;
step S112: acquiring, from a relay protection management information system of a substation, action processes and breaking current values of circuit breakers in a circuit breaker protection apparatus, a line protection apparatus and a relevant-element protection apparatus;
step S113: acquiring, from a fault recording apparatus, a value of a fault current broken by the circuit breaker and an action process of the three-phase contacts;
step S114: acquiring, from a circuit breaker cluster cloud database, inherent parameters related to the circuit breaker, where the inherent parameters include national technical standards for circuit breakers, design parameters of manufacturers of circuit breakers, debugging and acceptance parameters, device defect records, and device reliability statistics, and further include action characteristic inspection, insulation preventive test and SF₆ gas inspection;
step S115: performing history data analysis, trend analysis, variable analysis, comparison analysis and factor analysis, based on the acquired working parameters of the circuit breaker and the acquired inherent parameters related to the circuit breaker; and
step S116: invoking, based on the analysis results, a device state security risk evaluation module, an optimal device maintenance solution ranking module and a mobile terminal online dynamic warning module, to obtain a running and maintenance decision recommendation.

Furthermore, the circuit breaker cluster cloud database includes a real-time circuit breaker monitoring database for providing real-time working parameters of the circuit breaker, a circuit breaker technique supervision database for providing inherent parameters of the circuit breaker, a circuit breaker security risk technical indicator database for providing security risk technical indicators of the circuit breaker, and a circuit breaker warehouse spare part database.

Furthermore, the data in the circuit breaker technique supervision database for providing inherent parameters of the circuit breaker includes: waveforms, speeds, time, overtravel, opening range and bounce that are related to opening and closing operations; the voltage and current of an operating coil; and the action time and power of an iron core.

Furthermore, the circuit breaker security risk technical indicator database for providing security risk technical indicators of the circuit breaker includes a power grid system risk database, a circuit breaker ontological risk database, and an inspection and repair task risk database.

Furthermore, the data in the circuit breaker warehouse spare part database for providing specification data of the circuit breaker includes specification parameters, with the specification parameters including: the brand of a main device; and names, specifications and model numbers of spare parts, and so on.

The present invention has the following advantages over the prior art:
1. High-quality data are extracted separately from an automation system, a relay protection management information system, a fault recording apparatus, and various cloud databases such as a technical supervision database and a warehouse spare part database, and unique processional databases are created for circuit breaker elements, so as to lay the foundation for smart analysis.
2. Not only a single circuit breaker is intelligently monitored, but also a cluster of circuit breakers (different voltage levels, different model numbers, different regions, and different batches) can be intelligently monitored.
3. The smart multi-dimensional big data analysis is established on the basis of a real-time circuit breaker monitoring database, a circuit breaker technique supervision database, a circuit breaker security risk technical indicator database and a circuit breaker warehouse spare part database, and thus has a high reliability, and the above four databases can be upgraded automatically or manually as needed.
4. A circuit breaker device state security risk evaluation function and an optimal device maintenance solution ranking function can be provided, the blindness of inspection and repair of the circuit breaker during power outage in the power system can be reduced, and the power supply cost can be reduced.
5. It is possible to interface with spare part inventories for warehousing and logistics, which facilitates the deployment of inspection and repair resources and inventory management inside a company, improves the inventory turnover ratio, and saves warehousing and logistics funds.
6. Online dynamic warning over a mobile terminal (a hand phone, a tablet computer, a notebook computer, or the like) can be achieved.

### Brief Description of Drawings

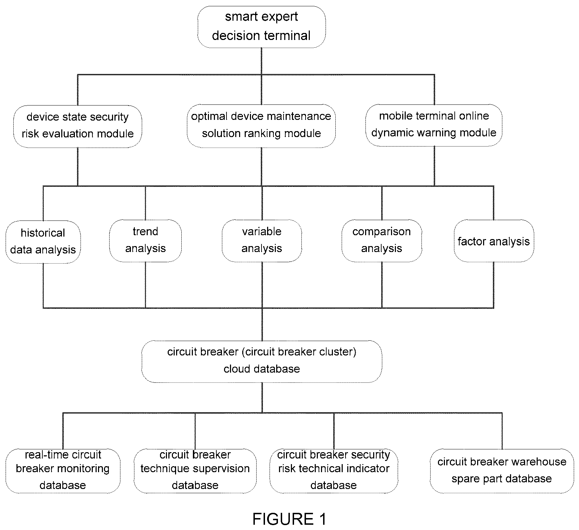

Figure 1 is a system structural diagram of the present invention;

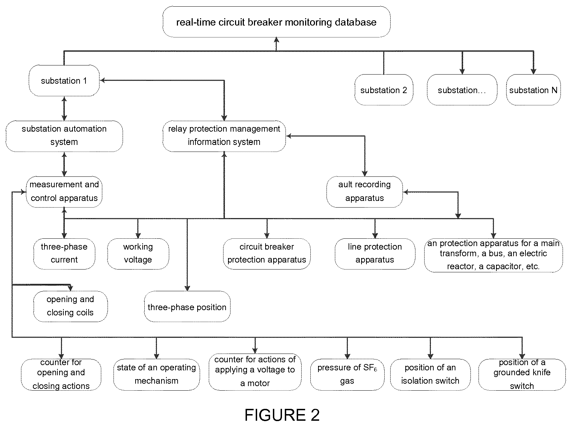

Figure 2 is a diagram of a real-time circuit breaker monitoring database of the present invention;

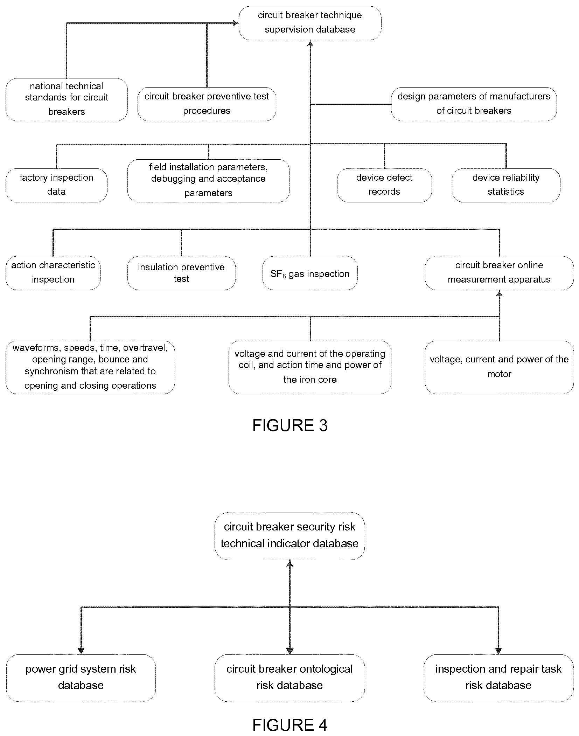

Figure 3 is a diagram of a circuit breaker technique supervision database of the present invention;
Figure 4 is a diagram of a circuit breaker security risk technical indicator database of the present invention;

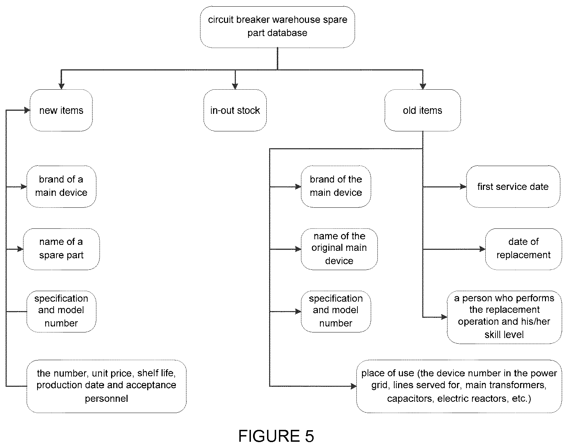

Figure 5 is a diagram of a circuit breaker warehouse spare part database; and

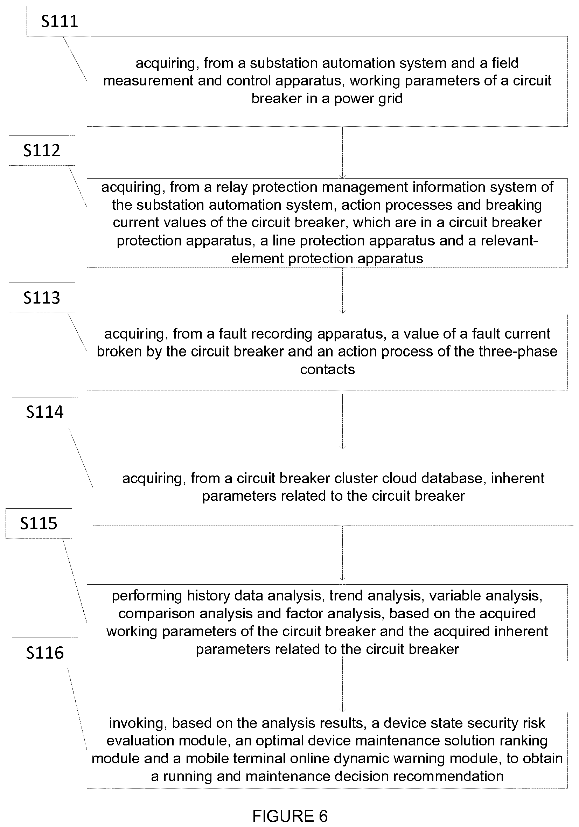

Figure 6 is a flow chart of a method of monitoring a circuit breaker using a smart multi-dimensional big data analyzing expert system for a high-voltage circuit breaker in a power grid according to the present invention.

### Detailed Description of Embodiments

The present invention will be described further below with reference to the accompanying drawings. It will be understood that these embodiments are only intended to be illustrative of the invention rather than limiting the scope of the invention. Modifications of that those skilled in the art would make to the invention in various equivalent forms upon reading the invention would fall within the scope as defined in the claims appended hereto. The scope of protection is defined by the appended claims.

The present invention provides a smart multi-dimensional big data analyzing expert system for a high-voltage circuit breaker in a power grid. The smart multi-dimensional big data analyzing expert system for a high-voltage circuit breaker in a power grid includes a circuit breaker cluster cloud database and a smart expert decision terminal. The circuit breaker cluster cloud database includes a real-time circuit breaker monitoring database, a circuit breaker technique supervision database, a circuit breaker security risk technical indicator database and a circuit breaker warehouse spare part database. The smart expert decision terminal includes a device security risk evaluation module, an optimal device maintenance solution ranking module and a mobile terminal online dynamic warning module. The circuit breaker cluster cloud database dynamically acquires data, and the smart expert decision terminal performs history data analysis, trend analysis, variable analysis, comparison analysis and factor analysis on the acquired data.

Furthermore, the real-time circuit breaker monitoring database includes a working voltage, a working current, states of opening and closing coils, positions of three-phase contacts, a counter for opening and closing actions, the state of an operating mechanism, a counter for actions of applying a voltage to a motor, the pressure of SF₆ gas, the position of an isolation switch, and the position of a grounded knife switch, which are acquired from a substation automation system and a field measurement and control apparatus.

Furthermore, action processes and breaking current values of the circuit breaker, which are in a circuit breaker protection apparatus, a line protection apparatus and a relevant-element (e.g., a main transformer, a bus, a reactor and a capacitor) protection apparatus, are acquired from a relay protection management information system of the substation automation system.

Furthermore, a fault recording apparatus is further included, and a value of a fault current broken by the circuit breaker and an action process of the three-phase contacts are acquired from the fault recording apparatus.

Furthermore, inherent design parameters of the circuit breaker are further included, and the inherent design parameters include: waveforms, speeds, time, overtravel, opening range and bounce that are related to opening and closing operations; the voltage and current of an operating coil; and an action time and power of an iron core.

The present invention also provides a method of monitoring a circuit breaker using the above mentioned smart multi-dimensional big data analyzing expert system for a high-voltage circuit breaker in a power grid, and the method includes the following steps:
step S111: acquiring, from a substation automation system and a field measurement and control apparatus, working parameters of a circuit breaker in a power grid, where the working parameters in the power grid includes a working voltage and a working current of the circuit breaker, states of opening and closing coils, positions of three-phase contacts, a counter for opening and closing actions, a state of an operating mechanism, a counter for actions of applying a voltage to a motor, a pressure of SF₆ gas, a position of an isolation switch, and a position of a grounded knife switch;
step S112: acquiring, from a relay protection management information system of a substation, action processes and breaking current values of circuit breakers in a circuit breaker protection apparatus, a line protection apparatus and a relevant-element (e.g., a main transformer, a bus, a reactor and a capacitor) protection apparatus;
step S113: acquiring, from a fault recording apparatus, a value of a fault current broken by the circuit breaker and an action process of the three-phase contacts;
step S114: acquiring, from a circuit breaker cluster cloud database, inherent parameters related to the circuit breaker, where the inherent parameters include national technical standards for circuit breakers, design parameters of manufacturers of circuit breakers, debugging and acceptance parameters, device defect records, and device reliability statistics;
step S115: performing history data analysis, trend analysis, variable analysis, comparison analysis and factor analysis, based on the acquired working parameters of the circuit breaker and the acquired inherent parameters related to the circuit breaker; and
step S116: invoking, based on the analysis results, a device state security risk evaluation module, an optimal device maintenance solution ranking module and a mobile terminal online dynamic warning module, to obtain a running and maintenance decision recommendation.

Furthermore, the circuit breaker cluster cloud database includes a real-time circuit breaker monitoring database for providing real-time working parameters of the circuit breaker, a circuit breaker technique supervision database for providing inherent parameters of the circuit breaker, a circuit breaker security risk technical indicator database for providing security risk technical indicators of the circuit breaker, and a circuit breaker warehouse spare part database.

Furthermore, the data in the circuit breaker technique supervision database for providing inherent parameters of the circuit breaker includes: waveforms, speeds, time, overtravel, opening range and bounce that are related to opening and closing operations; the voltage and current of an operating coil; and the action time and power of an iron core.

Furthermore, the circuit breaker security risk technical indicator database for providing security risk technical indicators of the circuit breaker includes a power grid system risk database, a circuit breaker ontological risk database, and an inspection and repair task risk database.

Furthermore, the data in the circuit breaker warehouse spare part database for providing specification data of the circuit breaker includes specification parameters, with the specification parameters including: the brand of a main device; and names, specifications and model numbers of spare parts, and so on.

In addition, the present invention provides a smart multi-dimensional big data analyzing expert system for a high-voltage circuit breaker in a power grid to remove the isolation of information on the high-voltage circuit breaker in eight areas, with the eight area including a substation automation system, a relay protection management information system, a fault recording management system, an online monitoring system, a warehouse spare part management system, a preventive test technique supervision and management system, a running and maintenance management system, and an original device supervising manufacture and detection monitoring system, and the expert system is a system for providing, based on wide area information technology, online monitoring and dynamic evaluation as well as warning and management control to a circuit breaker device. The system is composed of two parts, which are a high-voltage circuit breaker cluster cloud database and a smart expert decision terminal. The data extracted from the high-voltage circuit breaker cluster cloud database is derived from integrated data about the running of the circuit breaker or the circuit breaker cluster (hereinafter collectively referred to as the circuit breaker). The smart expert decision terminal includes a device state security risk evaluation module, an optimal device maintenance solution ranking module and a mobile terminal online dynamic warning module, which are provided on the basis of the functions of multi-dimensional smart analysis, such as history data analysis, trend analysis, variable analysis, comparison analysis and factor analysis.
1) The circuit breaker cluster cloud database is composed of four parts, which are a real-time circuit breaker monitoring database, a circuit breaker technique supervision database, a circuit breaker security risk indicator database, and a circuit breaker warehouse spare part database.

### 1.1) Real-time circuit breaker monitoring database:

The real-time circuit breaker monitoring database acquires, from a substation automation system and a field measurement and control apparatus, a working voltage and a working current of a circuit breaker device, states of opening and closing coils, the position of three-phase contacts, a counter for opening and closing actions, the state of an operating mechanism, a counter for actions of applying a voltage to a motor, the pressure of SF₆ gas, the position of an isolation switch, and the position of a grounded knife switch.

It acquires, from a relay protection management information system of the substation, action processes and breaking current values of the circuit breaker, which are in a circuit breaker protection apparatus, a line protection apparatus and a relevant-element (e.g., a main transformer, a bus, a reactive and a capacitor) protection apparatus.

It acquires, from a fault recording apparatus, a value of a fault current broken by the circuit breaker and an action process of the three-phase contacts.

In the above process, a circuit breaker cluster cloud database composed of different substations, different brands, and different model numbers may be defined as required.

### 1.2) Circuit breaker technique supervision database:

The circuit breaker technique supervision database includes national technical standards for circuit breakers, circuit breaker preventive test procedures, design parameters of manufacturers of circuit breakers, as well as factory inspection data, field installation parameters, debugging and acceptance parameters, device defect records, and device reliability statistics, and further includes action characteristic inspection, insulation preventive test, and SF₆ gas inspection.

The circuit breaker technique supervision database also includes data acquired from a circuit breaker online measurement apparatus provided specially for online monitoring of the circuit breaker, such data may be: for example, waveforms, speeds, time, overtravel, opening range, bounce and synchronism that are related to opening and closing operations of the operating mechanism; the voltage and current of the operating coil, and the action time and power of the iron core; and the voltage, current and power of the motor.

### 1.3) Circuit breaker security risk technical indicator database:

It includes a power grid system risk database, a circuit breaker ontological risk database, and an inspection and repair task risk database.

### 1.4) Circuit breaker warehouse spare part database:

It includes new items, old items and in-out stock. The contents of the new items include: the brand of a main device; and the name, specification and model number, the number, unit price, shelf life, production date, and acceptance personnel of a spare part. The contents of the old items include: the brand of the main device; the name, specification, model number, place of use (the device number in the power grid, lines served for, main transformers, capacitors, electric reactors, etc.), the first service date, and the date of replacement; and a person who performs the replacement operation and his/her skill level.

### 2) Functions of the smart expert decision terminal:

The acquisition of the cloud data of the circuit breaker cluster is carried out dynamically, and is carried out based on the invoking of history data analysis, trend analysis, variable analysis, comparison analysis and factor analysis functions possessed by the smart expert decision terminal.

The smart terminal provides the following functions:
The following analysis and decision-making functions are provided in the framework of a smart strategy.

The first function: a circuit breaker with the highest breaking current may be obtained through ranking, and the attention is focused on the monitoring of this circuit breaker's electrical and mechanical characteristics, and is paid to comparison between data of a power-outage preventive test of this circuit breaker and historical data.

The second function: a circuit breaker with the highest number of actions may be obtained through ranking, the attention is paid to this circuit breaker's electrical and mechanical characteristics, and at the same time, a suggestion is put forward that the operation order should be arranged reasonably (for example, the numbers of operations of circuit breakers for switching a capacitor bank should be equalized), and the smart terminal can be combined directly with a remote control system to achieve an automatic operation of the circuit breaker.

The third function: a circuit breaker with the greatest number of inspections and repairs during power outage may be obtained through ranking, the attention is paid to the type, name and model number of the spare part replacing this circuit breaker, and to the skill level of a person who performs the replacement operation and the upgrading thereof, and the main influence factors are analyzed and improvement is made accordingly.

The fourth function: a circuit breaker with the longest inspection and repair time during power outage may be screened out, the attention is paid to the rationality of the inspection and repair scheme, and the main influence factors are analyzed and improvement is made accordingly.

The fifth function: a circuit breaker with the highest cost of inspection and repair is screened out, and the attention is paid to the rationality of the inspection and repair scheme.

The sixth function: big data analysis is performed on historical data of the circuit breakers in accordance with the brand, model number and batch, to find out trends of changes in electrical characteristics, mechanical characteristics, and SF₆ insulation characteristics of each circuit breaker or circuit breaker cluster, and an arrangement of inspection and repair works is checked based on the trends, to find unsafe hazards and signs therefrom.

The seventh function: online big data analysis is performed, based on wide area information technology, on the speeds of opening and closing operations of the circuit breaker and the coordination of actions of the operating mechanism, to identify major potential hazards with mechanical failures, an operational warning is given to the device having a potential security hazard, and even the operation of the circuit breaker having a major potential hazard is stopped.

The eighth function: evaluation and analysis are performed on the risks that the circuit breaker brings to the power grid, devices and tasks, and risk control measures are put forward, these measures including contents such as supplier and contractor management, security technology, prevention and correction, emergency and accident management, and production management.

The ninth function: a mobile warning signal is sent, based on the result of the multi-dimensional big data analysis, to a security technical manager, and the manager can access relevant information through a terminal such as a tablet computer, a hand phone and a notebook computer.

The tenth function: targeted improvements of structural designs, qualities of spare parts, skill training of repairers and the like are provided by the manufacturers of circuit breakers according to the analysis results of the above functions, to further enhance the improvement effect of the above functions, so as to improve the running and maintenance of the circuit breakers as well as the safe and economic running level of the circuit breakers.

The smart multi-dimensional big data analyzing expert system for a circuit breaker in a power grid is implemented by the following steps.

Step 1: acquiring data from a real-time monitoring database.

A working voltage and a working current of a circuit breaker device, states of opening and closing coils, the positions of three-phase contacts, a counter for opening and closing actions, the state of an operating mechanism, a counter for actions of applying a voltage to a motor, the pressure of SF₆ gas, the position of an isolation switch, and the position of a grounded knife switch are mainly acquired from a substation automation system and a field measurement and control apparatus.

Step 2: acquiring data from a circuit breaker technique supervision database.

The circuit breaker technique supervision database includes national technical standards for circuit breakers, circuit breaker preventive test procedures, design parameters of manufacturers of circuit breakers, as well as factory inspection data, field installation parameters, debugging and acceptance parameters, device defect records, and device reliability statistics, and further includes action characteristic inspection, preventive insulation test, and SF₆ gas inspection.

The circuit breaker technique supervision database also includes data acquired from a circuit breaker online measurement apparatus provided specially for online monitoring of the circuit breaker, such data may be: for example waveforms, speeds, time, overtravel, opening range, bounce and synchronism that are related to opening and closing operations of the operating mechanism; the voltage and current of the operating coil, and the action time and power of the iron core; and the voltage, current and power of the motor.

Step 3: acquiring data from a circuit breaker security risk technical indicator database.

The circuit breaker security risk technical indicator database includes a power grid system risk database, a circuit breaker ontological risk database, and an inspection and repair task risk database.

Step 4: acquiring data from a circuit breaker warehouse spare part database.

The circuit breaker warehouse spare part database mainly includes new items, old items and in-out stock management. The contents of the new items include: the brand of a main device; and the name, specification and model number, the number, unit price, shelf life, production date, and acceptance personnel of a spare part. The contents of the old items include: the brand of the main device; the name, specification, model number, place of use (the device number in the power grid, lines served for, main transformers, capacitors, electric reactors, etc.), the first service date, and the date of replacement; and a person who performs the replacement operation and his/her skill level.

The data in the above database have the highest data quality in the power system, and are very critical to ensuring the accuracy of the smart big data analysis.

Step 5: analyzing the above four kinds of data by using history data analysis, trend analysis, variable analysis, comparison analysis and factor analysis, respectively.

Step 6: invoking a device state security risk evaluation module, an optimal device maintenance solution ranking module, and a mobile terminal online dynamic warning module as required, to obtain a running and maintenance decision recommendation. After the decision recommendation or the smart strategy is gradually optimized and perfected, the system of the present invention can also interface with a remote control system to dynamically control the circuit breaker.

Based on the smart multi-dimensional big data analysis provided by the apparatus of the present invention, a running and maintenance strategy, such as continuation of running, stop of the running, or an inspection and repair plan, is proposed, so as to carry out the full life cycle management of the circuit breaker in the power system, to achieve the objective of the scientific and economic running and maintenance as well as the improvement of the security level.

The functions described above are merely illustrative of preferred embodiments of the present invention and are not intended to limit the present invention. It would be understood by those skilled in the art that various modifications and variations could be made to the present invention. Equivalent alternatives made within the principle of the present invention are to be embraced in the scope of protection of the present invention as defined in the claims.

## Claims

1. A smart multi-dimensional big data analyzing expert system for a high-voltage circuit breaker in a power grid,
the smart multi-dimensional big data analyzing expert system for a high-voltage circuit breaker in a power grid comprises
a circuit breaker cluster cloud database and
a smart expert decision terminal,
wherein the circuit breaker cluster cloud database comprises
a real-time circuit breaker monitoring database, wherein data in the real-time circuit breaker monitoring database provides real-time working parameters of the circuit breaker,
a circuit breaker technique supervision database, wherein data in the circuit breaker technique supervision database provides inherent parameters of the circuit breaker,
a circuit breaker security risk technical indicator database, wherein data in the circuit breaker security risk technical indicator database provides security risk technical indicators, wherein the circuit breaker security risk technical indicator database for providing security risk technical indicators of the circuit breaker comprises a power grid system risk database, a circuit breaker ontological risk database, and an inspection and repair task risk database, and
a circuit breaker warehouse spare part database, wherein data in the circuit breaker warehouse spare part database provides specification data of the circuit breaker, wherein data in the circuit breaker warehouse spare part database comprises specification parameters, with the specification parameters including: a brand of a main device; and names, specifications and model numbers of spare parts,
wherein the smart expert decision terminal comprises
a device state security risk evaluation module configured to evaluate device security risks,
an optimal device maintenance solution ranking module configured to rank device maintenance solutions, and
a mobile terminal online dynamic warning module configured to provide an online dynamic warning over a mobile terminal,
wherein the circuit breaker cluster cloud database is configured to dynamically acquire data, and the smart expert decision terminal is configured to perform history data analysis, trend analysis, variable analysis, comparison analysis and factor analysis on the acquired data,
wherein the smart multi-dimensional big data analyzing expert system is configured to monitor a circuit breaker, the monitoring comprising steps of:
acquiring (Sill), from a substation automation system and a field measurement and control apparatus, working parameters of the circuit breaker in a power grid, wherein the working parameters in the power grid comprises a working voltage and a working current of the circuit breaker, states of opening and closing coils, positions of three-phase contacts, a counter for opening and closing actions, a state of an operating mechanism, a counter for actions of applying a voltage to a motor, a pressure of SF₆ gas, a position of an isolation switch, and a position of a grounded knife switch;
acquiring (S112), from a relay protection management information system of a substation, action processes and breaking current values of the circuit breaker, which are in a circuit breaker protection apparatus, a line protection apparatus and a relevant-element protection apparatus;
acquiring (S113), from a fault recording apparatus, a value of a fault current that breaks the circuit breaker and an action process of the three-phase contacts;
acquiring (S114), from the circuit breaker cluster cloud database, inherent parameters related to the circuit breaker, wherein the inherent parameters comprise national technical standards for circuit breakers, design parameters of manufacturers of circuit breakers, debugging and acceptance parameters, device defect records, and device reliability statistics;
performing (S115) history data analysis, trend analysis, variable analysis, comparison analysis and factor analysis, based on the acquired working parameters of the circuit breaker and the acquired inherent parameters related to the circuit breaker; and
invoking (S116), based on the analysis results, a device state security risk evaluation module, an optimal device maintenance solution ranking module and a mobile terminal online dynamic warning module, to obtain a running and maintenance decision recommendation.

2. The smart multi-dimensional big data analyzing expert system for a high-voltage circuit breaker in a power grid according to claim 1, **characterized in that** data in the real-time circuit breaker monitoring database comprises a working voltage, a working current, states of opening and closing coils, positions of three-phase contacts, a counter for opening and closing actions, a state of an operating mechanism, a counter for actions of applying a voltage to a motor, a pressure of SF₆ gas, a position of an isolation switch, and a position of a grounded knife switch, which are acquired from a substation automation system and a field measurement and control apparatus.

3. The smart multi-dimensional big data analyzing expert system for a high-voltage circuit breaker in a power grid according to claim 1 or 2, **characterized in that** action processes and breaking current values of the circuit breaker, which are in a circuit breaker protection apparatus, a line protection apparatus and a relevant-element protection apparatus, are acquired from a relay protection management information system and a substation automation system.

4. The smart multi-dimensional big data analyzing expert system for a high-voltage circuit breaker in a power grid according to any one of claims 1 to 3, **characterized in that**
the smart multi-dimensional big data analyzing expert system is configured to acquire information regarding the circuit breaker from eight areas, the eight areas including a substation automation system, a relay protection management information system, a fault recording management system, an online monitoring system, a warehouse spare part management system, a preventive test technique supervision and management system, a running and maintenance management system, and an original device supervising manufacture and detection monitoring system, and that the smart multi-dimensional big data analyzing expert system is a system for providing, based on wide area information technology, online monitoring and dynamic evaluation as well as warning and management control to a circuit breaker device.

5. The smart multi-dimensional big data analyzing expert system for a high-voltage circuit breaker in a power grid according to claim 4, **characterized in that** the smart multi-dimensional big data analyzing expert system is configured to perform smart multi-dimensional big data analysis on a cluster of circuit breakers, with the circuit breakers in the cluster being at different voltage levels, different model numbers, different regions and different batches.

6. The smart multi-dimensional big data analyzing expert system for a high-voltage circuit breaker in a power grid according to claim 4, **characterized in that**
the smart multi-dimensional big data analyzing expert system is configured to provide the following analysis and decision-making functions of:
ranking breaking currents of circuit breakers to obtain a circuit breaker with the highest breaking current, and focusing attention on the monitoring of this circuit breaker's electrical and mechanical characteristics, and paying attention to comparison between data of a power-outage preventive test of this circuit breaker and historical data;
ranking the numbers of actions of the circuit breakers to obtain a circuit breaker with the highest number of actions, paying attention to this circuit breaker's electrical and mechanical characteristics, and at the same time, putting forward a suggestion that an operation order should be arranged reasonably, wherein automatic operations of the circuit breakers can be achieved by a direct combination with a remote control system;
ranking the numbers of inspections and repairs during power outage of the circuit breakers to obtain a circuit breaker with the greatest number of inspections and repairs during power outage, paying attention to the type, name and model number of a spare part replacing this circuit breaker, and to a skill level of a person who performs a replacement operation and upgrading of the skill level of the person, and analyzing main influence factors and making improvements accordingly;
ranking inspection and repair times during power outage of the circuit breakers to obtain a circuit breaker with the longest inspection and repair time during power outage, paying attention to rationality of an inspection and repair scheme, and analyzing main influence factors and making improvements accordingly;
ranking costs of inspection and repair of the circuit breakers to obtain a circuit breaker with the highest cost of inspection and repair, and paying attention to rationality of the inspection and repair scheme;
performing big data analysis on historical data of the circuit breakers in accordance with the brand, model number and batch, to find out trends of changes in electrical characteristics, mechanical characteristics, and SF₆ insulation characteristics of each circuit breaker or circuit breaker cluster, and checking, based on the trends, an arrangement of inspection and repair works to find unsafe hazards and signs;
performing, based on wide area information technology, online big data analysis on speeds of opening and closing operations of the circuit breakers as well as coordination of actions of the operating mechanism, to identify major potential hazards with mechanical failures, giving an operational warning to a device having a potential security hazard, and even stopping the operation of a circuit breaker having a major potential hazard;
performing evaluation and analysis on risks that the circuit breaker brings to the power grid, devices and tasks, and putting forward risk control measures, wherein the measures include supplier and contractor management, security technology, prevention and correction, emergency and accident management, as well as production management;
sending, based on a result of multi-dimensional big data analysis, a mobile warning signal to a security technical manager, so that the manager can access relevant information through a terminal, the terminal including a tablet computer, a hand phone and a notebook computer; and
providing, by manufacturers of circuit breakers according to the analysis results of the above functions, targeted improvements of structural designs, qualities of spare parts, skill training of repairers, to further enhance an improvement effect of the above functions, so as to improve running and maintenance of the circuit breakers as well as the safe and economic running level of the circuit breakers.

7. The smart multi-dimensional big data analyzing expert system according to any preceding claim, wherein the circuit breaker technique supervision database for providing inherent parameters of the circuit breaker comprises: waveforms, speeds, time, overtravel, opening range and bounce that are related to opening and closing operations; the voltage and current of an operating coil; and an action time and power of an iron core.

8. A power grid comprising a smart multi-dimensional big data analyzing expert system according to any preceding claim.

## Patentansprüche

1. Intelligentes Expertensystem zur Analyse mehrdimensionaler großer Daten für einen Hochspannungs-Leistungsschalter in einem Stromnetz, wobei das intelligente mehrdimensionale Expertensystem zur Analyse großer Datenmengen für einen Hochspannungs-Leistungsschalter in einem Stromnetz umfassend
eine Leistungsschalter-Cluster-Cloud-Datenbank und ein intelligentes Expertenentscheidungsterminal, wobei die Leistungsschalter-Cluster-Cloud-Datenbank umfasst:
eine Echtzeit-Leistungsschalterüberwachungsdatenbank, wobei Daten in der Echtzeit-Leistungsschalterüberwachungsdatenbank Echtzeit-Betriebsparameter des Leistungsschalters bereitstellen,
eine Leistungsschaltertechnik-Überwachungsdatenbank, wobei Daten in der Leistungsschaltertechnik-Überwachungsdatenbank inhärente Parameter des Leistungsschalters bereitstellen,
eine Datenbank mit technischen Indikatoren für Sicherheitsrisiken des Leistungsschalters, wobei Daten in der Datenbank mit technischen Indikatoren für Sicherheitsrisiken des Leistungsschalters technische Indikatoren für Sicherheitsrisiken bereitstellen, wobei die Datenbank mit technischen Indikatoren für Sicherheitsrisiken des Leistungsschalters eine Risikodatenbank für Stromnetze, eine Datenbank für ontologische Risiken des Leistungsschalters und eine Datenbank für Inspektions- und Reparaturaufgaben umfasst, und
eine Ersatzteildatenbank für das Leistungsschalterlager, wobei die Daten in der Ersatzteildatenbank für das Leistungsschalterlager Spezifikationsdaten des Leistungsschalters bereitstellen, wobei die Daten in der Ersatzteildatenbank für das Leistungsschalterlager Spezifikationsparameter umfassen, wobei die Spezifikationsparameter beinhalten: eine Marke einer Hauptvorrichtung; und Namen, Spezifikationen und Modellnummern von Ersatzteilen,
wobei das intelligente Expertenentscheidungsterminal umfasst:
ein Modul zur Bewertung des Sicherheitsrisikos des Gerätezustands, das dazu ausgelegt ist, Sicherheitsrisiken des Gerätes zu bewerten,
ein optimales Einstufungsmodul für Gerätewartungslösungen, das dazu ausgelegt ist, Gerätewartungslösungen zu bewerten, und
ein online-dynamisches Warnmodul für ein mobiles Terminal, das dazu ausgelegt ist, eine onlinedynamische Warnung über ein mobiles Terminal bereitzustellen,
wobei die Leistungsschalter-Cluster-Cloud-Datenbank dazu ausgelegt ist, Daten dynamisch zu erfassen, und das intelligente Expertenentscheidungsterminal dazu ausgelegt ist, Verlaufsdatenanalyse, Trendanalyse, Variablenanalyse, Vergleichsanalyse und Faktoranalyse der erfassten Daten durchzuführen, wobei das intelligente Expertensystem zur Analyse mehrdimensionaler großer Datenmengen dazu ausgelegt ist, einen Leistungsschalter zu überwachen, wobei die Überwachung die folgenden Schritte umfasst: Erfassen (S111) von Betriebsparametern des Leistungsschalters in einem Stromnetz von einem Umspannwerk-Automatisierungssystem und einer Feldmess- und Steuervorrichtung, wobei die Betriebsparameter im Stromnetz eine Betriebsspannung und einen Betriebsstrom des Leistungsschalters, Zustände von Öffnungs- und Schließspulen, Positionen von Drehstromkontakten, einen Zähler für Öffnungs- und Schließvorgänge, einen Zustand eines Betätigungsmechanismus, einen Zähler für Vorgänge zum Anlegen einer Spannung an einen Motor, einen Druck von SF₆-Gas, eine Position eines Trennschalters und eine Position eines geerdeten Messerschalters umfassen;
Erfassen (S112) von Vorgangsprozessen und Ausschaltstromwerten des Leistungsschalters, die sich in einer Leistungsschalter-Schutzvorrichtung, einer Leitungsschutzvorrichtung und einer Schutzvorrichtung für relevante Elemente befinden, von einem RelaisschutzmanagementInformationssystem einer Umspannstation;
Erfassen (S113) eines Wertes eines Fehlerstroms, der den Leistungsschalter unterbricht, von einer Fehleraufzeichnungsvorrichtung und eines Vorgangsprozesses der dreiphasigen Kontakte; Erfassen (S114) von inhärenten Parametern, die sich auf den Leistungsschalter beziehen, aus der Leistungsschalter-Cluster-Cloud-Datenbank, wobei die inhärenten Parameter nationale technische Normen für Leistungsschalter, Designparameter von Leistungsschalterherstellern, Debugging- und Abnahmeparameter, Gerätefehleraufzeichnungen und Gerätezuverlässigkeitsstatistiken umfassen;
Durchführen (S115) einer Verlaufsdatenanalyse, Trendanalyse, Variablenanalyse, Vergleichsanalyse und Faktoranalyse, basierend auf den erfassten Betriebsparametern des Leistungsschalters und den erfassten inhärenten Parametern in Bezug auf den Leistungsschalter; und
Aufrufen (S116), basierend auf den Analyseergebnissen, eines Evaluierungsmoduls für das Sicherheitsrisiko des Gerätezustands, eines optimalen Einstufungsmoduls für die Gerätewartungslösung und eines dynamischen Online-Warnmoduls für mobile Terminals, um eine Empfehlung für eine Betriebs- und Wartungsentscheidung zu erhalten.

2. Intelligentes mehrdimensionales Großdatenanalyse-Expertensystem für einen Hochspannungs-Leistungsschalter in einem Stromnetz nach Anspruch 1, **dadurch gekennzeichnet, dass** die Daten in der Echtzeit-Überwachungsdatenbank des Leistungsschalters eine Betriebsspannung, einen Betriebsstrom, Zustände von Öffnungs- und Schließspulen, Positionen von Drehstromkontakten, einen Zähler zum Öffnen und Schließen von Vorgängen, einen Zustand eines Betätigungsmechanismus, einen Zähler für Vorgänge zum Anlegen einer Spannung an einen Motor, einen Druck von SF₆-Gas, eine Position eines Trennschalters und eine Position eines geerdeten Messerschalters umfassen, die von einem Umspannwerk-Automatisierungssystem und einem Feldmess- und Steuergerät erfasst werden.

3. Intelligentes mehrdimensionales Großdatenanalyse-Expertensystem für einen Hochspannungs-Leistungsschalter in einem Stromnetz nach Anspruch 1 oder 2, **dadurch gekennzeichnet, dass** Vorgangsprozesse und Ausschaltstromwerte des Leistungsschalters, die sich in einer Leistungsschalter-Schutzvorrichtung, einer Leitungsschutzvorrichtung und einer Schutzvorrichtung für relevante Elemente befinden, von einem Relaisschutzmanagementinformationssystem und einem Umspannwerk-Automatisierungssystem erfasst werden.

4. Intelligentes mehrdimensionales Großdatenanalyse-Expertensystem für einen Hochspannungs-Leistungsschalter in einem Stromnetz nach einem der Ansprüche 1 bis 3, **dadurch gekennzeichnet, dass**
das intelligente mehrdimensionale Großdatenanalyse-Expertensystem dazu ausgelegt ist, Informationen über den Leistungsschalter aus acht Bereichen zu erfassen, wobei die acht Bereiche ein Umspannwerk-Automatisierungssystem, ein Relaisschutzmanagementinformationssystem, ein Fehleraufzeichnungsmanagementsystem, ein Online-Überwachungssystem, ein Lager-Ersatzteilmanagementsystem, ein präventives Prüftechnik-Überwachungs- und Managementsystem, ein Betriebs- und Wartungsmanagementsystem und ein Überwachungssystem das die Herstellung und Erkennung von Originalgeräten beaufsichtigt, und dass das intelligente mehrdimensionale Großdatenanalyse-Expertensystem ein System zum Bereitstellen, basierend auf Weitbereichsinformationstechnologie, Online-Überwachung und dynamischer Auswertung sowie Warn- und Verwaltungssteuerung für ein Leistungsschaltergerät ist.

5. Intelligentes mehrdimensionales Großdatenanalyse-Expertensystem für einen Hochspannungs-Leistungsschalter in einem Stromnetz nach Anspruch 4, **dadurch gekennzeichnet, dass**
das intelligente mehrdimensionale Großdatenanalyse-Expertensystem dazu ausgelegt ist, eine intelligente mehrdimensionale Großdatenanalyse an einem Cluster von Leistungsschaltern durchzuführen, wobei sich die Leistungsschalter im Cluster auf verschiedenen Spannungsniveaus, verschiedenen Modellnummern, verschiedenen Regionen und verschiedenen Chargen befinden.

6. Intelligentes mehrdimensionales Großdatenanalyse-Expertensystem für einen Hochspannungs-Leistungsschalter in einem Stromnetz nach Anspruch 4, **dadurch gekennzeichnet, dass** das intelligente mehrdimensionale Großdatenanalyse-Expertensystem dazu ausgelegt ist, die folgenden Analyse- und Entscheidungsfunktionen bereitzustellen:
Einstufen der Ausschaltströme von Leistungsschaltern, um einen Leistungsschalter mit dem höchsten Ausschaltstrom zu erhalten, und Fokussieren der Aufmerksamkeit auf die Überwachung der elektrischen und mechanischen Eigenschaften dieses Leistungsschalters und Beachten des Vergleichs zwischen den Daten einer präventiven Stromausfallprüfung dieses Leistungsschalters und historischen Daten;
Einstufen der Anzahl der Vorgänge der Leistungsschalter, um einen Leistungsschalter mit der höchsten Anzahl von Vorgängen zu erhalten, Beachten der elektrischen und mechanischen Eigenschaften dieses Leistungsschalters und gleichzeitig Unterbreiten eines Vorschlags, dass eine Betriebsordnung vernünftig angeordnet werden sollte, wobei die automatischen Operationen der Leistungsschalter durch eine direkte Kombination mit einem Fernsteuerungssystem erzielt werden können;
Einstufen der Anzahl der Inspektionen und Reparaturen während eines Stromausfalls der Leistungsschalter, um einen Leistungsschalter mit der größten Anzahl von Inspektionen und Reparaturen während eines Stromausfalls zu erhalten, Beachten von Typ, Name und Modellnummer eines Ersatzteils, das diesen Leistungsschalter ersetzt, sowie des Qualifikationsniveaus einer Person, die eine Austauschoperation durchführt, und Verbessern des Qualifikationsniveaus der Person, und Analysieren der wichtigsten Einflussfaktoren und Durchführen entsprechender Verbesserungen;
Einstufen der Inspektions- und Reparaturzeiten der Leistungsschalter bei Stromausfall, um einen Leistungsschalter mit der längsten Inspektions- und Reparaturzeit bei Stromausfall zu erhalten, Beachten der Rationalität eines Inspektions- und Reparaturplans, und Analysieren der wichtigsten Einflussfaktoren und Durchführen entsprechender Verbesserungen;
Einstufen der Kosten für die Inspektion und Reparatur der Leistungsschalter, um einen Leistungsschalter mit den höchsten Inspektions- und Reparaturkosten zu erhalten, und Beachten der Rationalität des Inspektions- und Reparaturplans;
Durchführen einer Großdatenanalyse der historischen Daten der Leistungsschalter in Übereinstimmung mit der Marke, der Modellnummer und der Charge, um Trends von Änderungen der elektrischen Eigenschaften, der mechanischen Eigenschaften und der SF₆-Isolationseigenschaften jedes Leistungsschalters oder Leistungsschalterclusters herauszufinden, und Überprüfen, basierend auf den Trends, einer Anordnung von Inspektions- und Reparaturarbeiten zum Auffinden von unsicheren Gefahren und Zeichen; Durchführen einer Online-Großdatenanalyse über die Geschwindigkeiten der Öffnungs- und Schließoperationen der Leistungsschalter sowie der Koordination der Vorgänge des Antriebsmechanismus, um größere potenzielle Gefahren bei mechanischen Ausfällen zu identifizieren, eine Betriebswarnung für ein Gerät mit einer potenziellen Sicherheitsgefahr zu geben und sogar den Betrieb eines Leistungsschalters mit einer potenziellen größeren Gefährdung einzustellen;
Durchführen einer Bewertung und Analyse der Risiken, die der Leistungsschalter in das Stromnetz, die Geräte und Aufgaben einbringt, und Vorbringen von Maßnahmen zur Risikokontrolle, wobei die Maßnahmen Lieferanten- und Auftragnehmermanagement, Sicherheitstechnologie, Prävention und Korrektur, Notfall- und Unfallmanagement sowie Produktionsmanagement umfassen;
Senden eines mobilen Warnsignals an einen sicherheitstechnischen Manager basierend auf dem Ergebnis einer mehrdimensionalen Großdatenanalyse, so dass der Manager über ein Terminal auf relevante Informationen zugreifen kann, wobei das Terminal einen Tablet-Computer, ein Handtelefon und einen Notebook-Computer beinhaltet; und
Bereitstellen von gezielten Verbesserungen der strukturellen Designs, der Qualität der Ersatzteile, der Schulung der Reparaturfachkräfte durch die Hersteller von Leistungsschaltern gemäß den Analyseergebnissen der oben genannten Funktionen, um eine Verbesserung der Wirkung der oben genannten Funktionen weiter zu verbessern, um den Betrieb und die Wartung der Leistungsschalter sowie das sichere und wirtschaftliche Betriebsniveau der Leistungsschalter zu verbessern.

7. Intelligentes mehrdimensionales Großdatenanalyse-Expertensystem nach einem der vorhergehenden Ansprüche, wobei die Überwachungsdatenbank für die Leistungsschaltertechnik zum Bereitstellen der inhärenten Parameter des Leistungsschalters umfasst: Wellenformen, Geschwindigkeiten, Zeit, Nachlauf, Öffnungsbereich und Prellverhalten, die sich auf Öffnungs- und Schließoperationen beziehen; die Spannung und den Strom einer Betriebsspule; und eine Vorgangszeit und Leistung eines Eisenkerns.

8. Stromnetz, umfassend ein intelligentes, mehrdimensionales, Großdatenanalyse-Expertensystem nach einem der vorhergehenden Ansprüche.

## Revendications

1. Système expert d'analyse intelligente de mégadonnées multidimensionnelles pour un disjoncteur à haute tension dans un réseau électrique, le système expert d'analyse intelligente de mégadonnées multidimensionnelles pour un disjoncteur à haute tension dans un réseau électrique comprend
une base de données de nuage de groupes de disjoncteurs et
un terminal de décision expert intelligent,
dans lequel la base de données de nuage de groupes de disjoncteurs comprend
une base de données de surveillance de disjoncteurs en temps réel, dans lequel des données dans la base de données de surveillance de disjoncteurs en temps réel fournissent des paramètres de fonctionnement en temps réel du disjoncteur,
une base de données de supervision technique de disjoncteurs, dans lequel des données dans la base de données de supervision technique de disjoncteurs fournissent des paramètres inhérents du disjoncteur,
une base de données d'indicateurs techniques de risque de sécurité de disjoncteurs, dans lequel des données dans la base de données d'indicateurs techniques de risque de sécurité de disjoncteurs fournissent des indicateurs techniques de risque de sécurité, dans lequel la base de données d'indicateurs techniques de risque de sécurité de disjoncteurs pour fournir des indicateurs techniques de risque de sécurité de disjoncteurs comprend une base de données de risques de système de réseau électrique, une base de données de risques ontologiques de disjoncteurs, et une base de données de risques de tâches d'inspection et de réparation, et
une base de données de pièces de rechange d'entrepôt de disjoncteurs, dans lequel des données dans la base de données de pièces de rechange d'entrepôt de disjoncteurs fournissent des données de spécification du disjoncteur, dans lequel des données dans la base de données de pièces de rechange d'entrepôt de disjoncteurs comprennent des paramètres de spécification, les paramètres de spécification incluant : une marque d'un dispositif principal; et des noms, des spécifications et des numéros de modèle de pièces de rechange,
dans lequel le terminal de décision d'expert intelligent comprend
un module d'évaluation des risques de sécurité d'état de dispositifs configuré pour évaluer des risques de sécurité de dispositifs,
un module de classement de solutions optimales de maintenance de dispositifs configuré pour classer des solutions de maintenance de dispositifs, et
un module d'avertissement dynamique en ligne de terminal mobile configuré pour fournir un avertissement dynamique en ligne sur un terminal mobile,
dans lequel la base de données de nuage de groupes de disjoncteurs est configurée pour acquérir des données de façon dynamique, et le terminal de décision expert intelligent est configuré pour effectuer une analyse de données d'historique, une analyse des tendances, une analyse de variables, une analyse de comparaisons et une analyse de facteurs sur les données acquises,
dans lequel le système expert d'analyse intelligente de mégadonnées multidimensionnelles est configuré pour surveiller un disjoncteur, la surveillance comprenant les étapes consistant à :
acquérir (S111), à partir d'un système d'automatisation de poste électrique et d'un appareil de mesure et de commande de terrain, des paramètres de fonctionnement du disjoncteur dans un réseau électrique, dans lequel les paramètres de fonctionnement dans le réseau électrique comprennent une tension de fonctionnement et un courant de fonctionnement du disjoncteur, des états d'ouverture et de fermeture de bobines, des positions de contacts triphasés, un compteur pour des actions d'ouverture et de fermeture, un état d'un mécanisme de commande, un compteur pour des actions d'application d'une tension à un moteur, une pression de gaz SF₆, une position d'un commutateur d'isolement, et une position d'un interrupteur à couteau mis à la terre;
acquérir (S112), à partir d'un système d'informations de gestion de protection de relais d'un poste électrique, des processus d'action et des valeurs de courant de déclenchement du disjoncteur, qui sont dans un appareil de protection de disjoncteur, un appareil de protection de ligne et un appareil de protection d'élément pertinent;
acquérir (S113), à partir d'un appareil d'enregistrement de défauts, une valeur d'un courant de défaut qui coupe le disjoncteur et un processus d'action des contacts triphasés;
acquérir (S114), à partir de la base de données de nuage de groupes de disjoncteurs, des paramètres inhérents liés au disjoncteur, dans lequel les paramètres inhérents comprennent des normes techniques nationales pour les disjoncteurs, des paramètres de conception de fabricants de disjoncteurs, des paramètres de mise au point et d'acceptation, des enregistrements de défauts de dispositifs, et des statistiques de fiabilité de dispositifs;
effectuer (S115) une analyse de données d'historique, une analyse des tendances, une analyse de variables, une analyse de comparaisons et une analyse de facteurs, sur la base des paramètres de fonctionnement acquis du disjoncteur et des paramètres inhérents acquis liés au disjoncteur; et
invoquer (S116), sur la base des résultats d'analyse, un module d'évaluation des risques de sécurité d'état de dispositifs, un module de classement de solutions optimales de maintenance de dispositifs et un module d'avertissement dynamique en ligne de terminal mobile, afin d'obtenir une recommandation de décision de fonctionnement et de maintenance.

2. Système expert d'analyse intelligente de mégadonnées multidimensionnelles pour un disjoncteur à haute tension dans un réseau électrique selon la revendication 1, **caractérisé en ce que** des données dans la base de données de surveillance de disjoncteurs en temps réel comprennent une tension de fonctionnement, un courant de fonctionnement, des états d'ouverture et de fermeture de bobines, des positions de contacts triphasés, un compteur pour des actions d'ouverture et de fermeture, un état d'un mécanisme de commande, un compteur pour des actions d'application d'une tension à un moteur, une pression de gaz SF₆, une position d'un commutateur d'isolement, et une position d'un interrupteur à couteau mis à la terre, qui sont acquis à partir d'un système d'automatisation de poste électrique et d'un appareil de mesure et de commande de terrain.

3. Système expert d'analyse intelligente de mégadonnées multidimensionnelles pour un disjoncteur à haute tension dans un réseau électrique selon la revendication 1 ou 2, **caractérisé en ce que** des processus d'action et des valeurs de courant de déclenchement du disjoncteur, qui sont dans un appareil de protection de disjoncteur, un appareil de protection de ligne et un appareil de protection d'élément pertinent, sont acquis à partir d'un système d'informations de gestion de protection de relais et d'un système d'automatisation de poste électrique.

4. Système expert d'analyse intelligente de mégadonnées multidimensionnelles pour un disjoncteur à haute tension dans un réseau électrique selon l'une quelconque des revendications 1 à 3, **caractérisé en ce que**
le système expert d'analyse intelligente de mégadonnées multidimensionnelles est configuré pour acquérir des informations concernant le disjoncteur à partir de huit zones, les huit zones comprenant un système d'automatisation de poste électrique, un système d'informations de gestion de protection de relais, un système de gestion d'enregistrement de défauts, un système de surveillance en ligne, un système de gestion de pièces de rechange d'entrepôt, un système de supervision technique et de gestion de tests préventifs, un système de gestion de fonctionnement et de maintenance, et un système de surveillance de fabrication de supervision et de détection de dispositifs d'origine, et
et **en ce que** le système expert d'analyse intelligente de mégadonnées multidimensionnelles est un système pour fournir, sur la base de la technologie de l'information à vaste zone, un suivi en ligne et une évaluation dynamique ainsi qu'un contrôle d'alerte et de gestion à un dispositif de disjoncteur.

5. Système expert d'analyse intelligente de mégadonnées multidimensionnelles pour un disjoncteur à haute tension dans un réseau électrique selon la revendication 4, **caractérisé en ce que**
le système expert d'analyse intelligente de mégadonnées multidimensionnelles est configuré pour effectuer une analyse intelligente de mégadonnées multidimensionnelles sur un groupe de disjoncteurs, les disjoncteurs dans le groupe étant à différents niveaux de tension, ayant différents numéros de modèle, étant de différentes régions et de différents lots.

6. Système expert d'analyse intelligente de mégadonnées multidimensionnelles pour un disjoncteur à haute tension dans un réseau électrique selon la revendication 4, **caractérisé en ce que**
le système expert d'analyse intelligente de mégadonnées multidimensionnelles est configuré pour fournir les fonctions d'analyse et de prise de décision suivantes :
classer des courants de déclenchement de disjoncteurs pour obtenir un disjoncteur avec le courant de déclenchement le plus élevé, et attirer l'attention sur la surveillance des caractéristiques électriques et mécaniques de ce disjoncteur, et prêter attention à la comparaison entre des données d'un test de prévention de panne de courant de ce disjoncteur et des données d'historique ;
classer le nombre d'actions des disjoncteurs pour obtenir un disjoncteur avec le plus grand nombre d'actions, prêter attention aux caractéristiques électriques et mécaniques de ce disjoncteur, et en même temps, faire une suggestion selon laquelle un ordre d'opérations doit être organisé de façon raisonnable, dans lequel des opérations automatiques des disjoncteurs peuvent être réalisées par une combinaison directe avec un système de commande à distance;
classer le nombre d'inspections et de réparations lors de panne de courant des disjoncteurs pour obtenir un disjoncteur avec le plus grand nombre d'inspections et de réparations pendant une panne de courant, prêter attention au type, au nom et au numéro de modèle d'une pièce de rechange remplaçant ce disjoncteur, et à un niveau de compétence d'une personne qui effectue une opération de remplacement et à l'amélioration du niveau de compétence de la personne, et analyser les principaux facteurs d'influence et apporter des améliorations en conséquence;
classer les temps d'inspection et de réparation pendant une panne de courant des disjoncteurs pour obtenir un disjoncteur avec le plus long temps d'inspection et de réparation pendant une panne de courant, prêter attention à la rationalité d'une procédure d'inspection et de réparation, et analyser les principaux facteurs d'influence et apporter des améliorations en conséquence;
classer des coûts d'inspection et de réparation des disjoncteurs pour obtenir un disjoncteur avec le coût le plus élevé d'inspection et de réparation, et prêter attention à la rationalité de la procédure d'inspection et de réparation;
effectuer une analyse de mégadonnées sur des données d'historique des disjoncteurs conformément à la marque, au numéro de modèle et au lot, pour connaître des tendances de l'évolution des caractéristiques électriques, des caractéristiques mécaniques et des caractéristiques d'isolement de SF₆ de chaque disjoncteur ou groupe de disjoncteurs, et vérifier, sur la base des tendances, un agencement de travaux d'inspection et de réparation pour trouver des risques et des signes dangereux; effectuer, sur la base de technologie de l'information à vaste zone, une analyse de mégadonnées en ligne sur des vitesses d'opérations d'ouverture et de fermeture des disjoncteurs ainsi que la coordination des actions du mécanisme d'exploitation, afin d'identifier les principaux risques potentiels avec des défaillances mécaniques, fournir un avertissement opérationnel à un dispositif présentant un danger potentiel pour la sécurité, et même interrompre le fonctionnement d'un disjoncteur présentant un danger potentiel majeur;
effectuer une évaluation et une analyse des risques que le disjoncteur fait courir au réseau électrique, à des dispositifs et à des tâches, et proposer des mesures de contrôle des risques, dans lequel les mesures comprennent la gestion des fournisseurs et des entrepreneurs, la technologie de sécurité, la prévention et la correction, la gestion des urgences et des accidents, ainsi la gestion de la production;
envoyer, sur la base du résultat de l'analyse de mégadonnées multidimensionnelles, un signal d'avertissement mobile à un gestionnaire technique de sécurité, de sorte que le gestionnaire puisse accéder aux informations pertinentes via un terminal, le terminal comprenant un ordinateur tablette, un téléphone à main et un ordinateur portable; et
fournir, par des fabricants de disjoncteurs en fonction des résultats d'analyse des fonctions susmentionnées, des améliorations ciblées de conceptions structurelles, de qualités des pièces de rechange, de la formation professionnelle des réparateurs, pour améliorer davantage l'effet d'amélioration des fonctions susmentionnées, de manière à améliorer le fonctionnement et la maintenance des disjoncteurs ainsi que le niveau de fonctionnement sûr et économique des disjoncteurs.

7. Système expert d'analyse intelligente de mégadonnées multidimensionnelles selon l'une quelconque des revendications précédentes, dans lequel la base de données de supervision technique de disjoncteurs pour fournir des paramètres inhérents du disjoncteur comprend : des formes d'onde, des vitesses, le temps, le dépassement de course, la plage d'ouverture et le rebond qui sont liés aux opérations d'ouverture et de fermeture; la tension et le courant d'une bobine d'actionnement; et un temps d'action et la puissance d'un noyau de fer.

8. Réseau électrique comprenant un système expert d'analyse intelligente de mégadonnées multidimensionnelles selon l'une quelconque des revendications précédentes.
